# FASCICULE DE BREVET EUROPEEN

(11) **EP 2 432 308 B1**
(45) Date de publication et mention de la délivrance du brevet: **11.03.2020**
(21) Numéro de dépôt: 11181989.2
(22) Date de dépôt: 20.09.2011
(51) Int. Cl.: H05K 7/20

(54) **DISPOSITIF DE PROTECTION D'UN SYSTÈME ÉLECTRONIQUE MONTÉ DANS UN RACK**
VORRICHTUNG ZUM SCHUTZ EINES FUR RACKMONTAGE AUSGELEGTEN ELEKTRONISCHEN SYSTEMS
PROTECTION DEVICE FOR ELECTRONIC SYSTEM MOUNTED IN A RACK

(30) Priorité: 20.09.2010 FR 1057503
(43) Date de publication de la demande: 21.03.2012
(73) Titulaire: Zodiac Aero Electric, 93100 Montreuil (FR)
(72) Inventeur: Abdesselam, Francis, 92500 RUEIL MALMAISON (FR)
(74) Mandataire: Casalonga, Axel

(56) Documents cités:
- WO-A2-2004/040724
- FR-A1- 2 905 556
- FR-A1- 2 910 779
- US-A- 6 147 834
- US-A1- 2002 139 554
- US-A1- 2003 151 894
- US-A1- 2010 066 172
- US-B1- 6 548 753

## Description

L'invention concerne la protection de systèmes électronique, en particulier les systèmes électroniques contenus dans des boîtiers montés dans des racks d'un système de rangement.

Les boîtiers actuels sont liés à un système de refroidissement externe qui, lors d'une panne, impose à la totalité des boîtiers montés dans des racks d'un même système de rangement une mise hors service ou un mode de fonctionnement dégradé. Les performances d'un système électronique contenu dans un tel boîtier sont réduites, et la disponibilité du système électronique devient nulle ou très faible.

Ainsi, il est nécessaire d'utiliser plusieurs systèmes de refroidissement redondants ou plusieurs systèmes électroniques redondants.

Lors d'un dysfonctionnement grave, un départ de feu ou de fumées peut apparaître au sein du système électronique. Les systèmes de refroidissement, utilisant une convection forcée d'air, sont susceptibles d'apporter une quantité d'oxygène importante qui entretient les flammes et peut présenter un risque de propagation des flammes vers les autres systèmes électroniques contenus dans d'autres boîtiers voisins.

Il est donc nécessaire de confiner les fumées à l'intérieur du boîtier et d'empêcher l'apport d'oxygène à un système électronique lors d'un départ de feu.

Les boîtiers utilisés actuellement présentent en outre une faible protection contre les perturbations électromagnétiques émises ou reçues par les systèmes électroniques.

On pourra se référer au document FR 2 910 779, qui décrit un boîtier d'un système électronique qui utilise un système de refroidissement par convection naturelle et forcée. Le boîtier contient un ensemble de radiateurs internes et externes aptes à compléter le refroidissement lors d'une panne de ventilateur.

La demande internationale WO 2010/028384 décrit un boîtier d'un système électronique comprenant un conduit d'évacuation d'air chaud. Le boîtier comprend en outre des ventilateurs pour obtenir une convection forcée.

On pourra en outre se référer au document WO 2005/074345 qui décrit un boîtier d'un système électronique qui comprend un système de refroidissement intégré au boîtier. Ce système de refroidissement comprend un ventilateur et un échangeur de chaleur. Les parois du boîtier sont équipées de persiennes aptes à laisser entrer de l'air lors d'une défaillance du système de refroidissement intégré.

Les boîtiers décrits dans ces documents ne permettent pas de confiner les fumées ou d'empêcher l'apport d'oxygène lors d'un départ de feu.

L'invention a donc pour but de résoudre les inconvénients mentionnés ci-dessus, et en particulier, de proposer un dispositif de protection d'un système électronique apte à confiner les fumées à l'intérieur du dispositif et à empêcher l'apport d'oxygène lors d'un départ de feu.

L'invention a également pour but de proposer un système de refroidissement autonome pour chaque boîtier monté dans un rack d'un système de rangement pouvant recevoir plusieurs boîtiers.

Un autre but de l'invention est de fournir une convection forcée efficace et robuste à la panne d'un ventilateur.

L'invention a donc pour objet, un dispositif de protection d'un système électronique selon la revendication 1.

La paroi de la conduite est au moins en partie hermétique.

Le conduit hermétique permet de refroidir le système électronique sans apporter d'oxygène directement à ce système électronique. En outre, un départ de feu ne peut pas se propager aux autres boîtiers et les fumées sont confinées.

Avantageusement, le boîtier est métallique.

L'utilisation d'un boîtier métallique permet d'obtenir une protection contre les perturbations électromagnétiques émises et reçues par le système électronique.

En outre, le système de refroidissement comporte un premier ventilateur associé à la première ouverture et un deuxième ventilateur associé à la deuxième ouverture.

Le système de refroidissement utilise donc une convection forcée susceptible d'entretenir une ventilation lors de la panne d'un des deux ventilateurs.

Le système de refroidissement comporte des moyens de dissipation de chaleur situés entre le premier ventilateur et le deuxième ventilateur.

Le système électronique peut être relié au boîtier par un support apte à dissiper la puissance perdue par le système électronique.

Ainsi, la puissance perdue par le système est extraite par un transfert de chaleur par conduction avant que le système de refroidissement ne l'évacue par un transfert par convection.

Le système de refroidissement peut être relié à un système d'extraction d'air.

Le système d'extraction d'air permet de récupérer l'air chaud en sortie de plusieurs boîtiers ayant chacun un système de refroidissement autonome, et de ne pas réchauffer l'air environnant.

Avantageusement, le flux d'air traversant le système de refroidissement circule de la première ouverture vers la deuxième ouverture ou de la deuxième ouverture vers la première ouverture.

La première face peut être la face accessible du boîtier ou face avant, et la deuxième face est la face arrière du boîtier.

En variante, la première face est la face inférieure du boîtier, et la deuxième face est la face supérieure du boîtier.

De ce fait, lorsque le boîtier est rangé dans un rack de manière verticale, l'air circule entre les faces qui ne sont pas accolées aux faces d'un boîtier voisin.

Selon un autre mode de réalisation, le dispositif comprend sur la première face deux ouvertures, sur la deuxième face deux ouvertures, et deux systèmes de refroidissement comprenant chacun une conduite reliant les ouvertures de la première face aux ouvertures de la deuxième face.

D'autres buts, caractéristiques et avantages de l'invention apparaîtront à la lecture de la description suivante, donnée uniquement à titre d'exemple non limitatif, et faite en référence aux dessins annexés, dans lesquels :
- la figure 1 représente une vue en perspective d'un système de rangement dans lequel sont rangés plusieurs boîtiers selon l'invention ;
- la figure 2 représente une vue en perspective de l'intérieur d'un boîtier selon l'invention ;
- la figure 3 représente une vue en perspective en éclaté d'un système de refroidissement selon l'invention;
- la figure 4 représente une vue en perspective d'un deuxième mode de réalisation d'un boîtier selon l'invention ;
- la figure 5 représente une vue en perspective d'un autre mode de réalisation d'un boîtier selon l'invention dans lequel le système de refroidissement est relié à un système d'extraction d'air extérieur ; et
- la figure 6 représente une vue en perspective d'un système de rangement dans lequel sont rangés plusieurs boîtiers selon un autre mode de réalisation de l'invention.

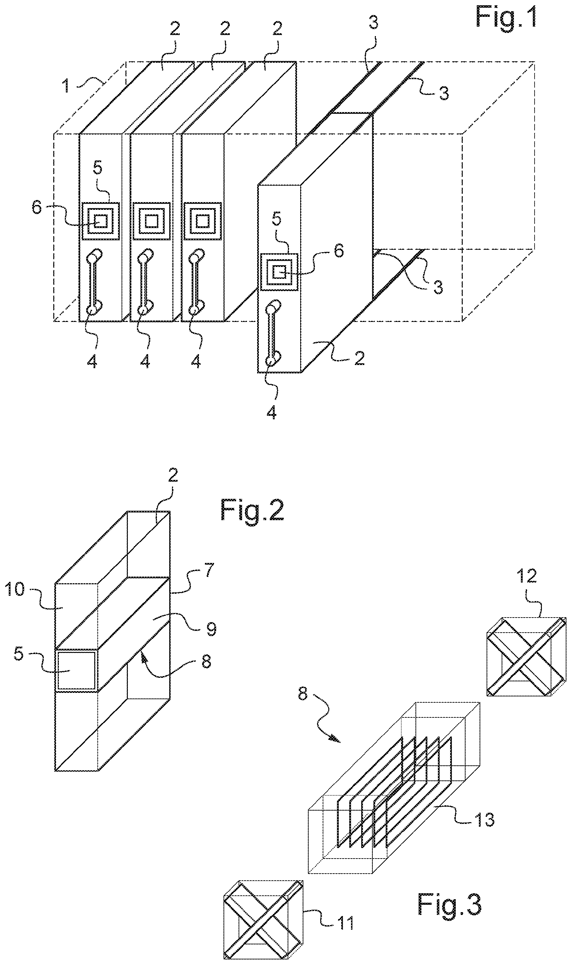

Sur la figure 1 est représenté de manière schématique un système de rangement 1. Un certain nombre de boîtiers 2 sont rangés dans le système de rangement 1 pour systèmes électroniques placés dans des boîtiers 2. Les boîtiers 2 sont maintenus par des rails 3 représentés en trait plein et qui forment un rack. Le système de rangement 1 peut être une armoire et peut contenir plusieurs étages similaires à celui représenté sur la figure 1. Le système de rangement peut également être basculé afin d'accueillir des boîtiers 2 rangés horizontalement.

Chaque boîtier 2 peut être manipulé et sorti du rack au moyen d'une poignée 4. Une première ouverture 5 est représentée sur la face accessible ou face avant du boîtier 2. Cette première ouverture 5 comporte une grille 6.

Le boîtier 2 est métallique, les systèmes électroniques destinés à être insérés à l'intérieur de ce boîtier 2 sont donc protégés contre les perturbations électromagnétiques émises et reçues.

Sur la figure 2 est représenté l'intérieur d'un boîtier 2. Le châssis métallique de ce boîtier 2 n'est pas représenté sur cette figure. La grille 6 n'est pas non plus représentée et l'on reconnaît l'ouverture 5. Une deuxième ouverture 7 est située sur la face opposée à la face dans laquelle est située la première ouverture 5.

Un système de refroidissement 8 comprenant une conduite 9 reliant les ouvertures 5 et 7 est disposé à l'intérieur du boîtier 2. Cette conduite 9 est métallique, et sa paroi est hermétique.

Un support 10, destiné à recevoir un système électronique, est disposé sur une paroi du boîtier 2. Ce support 10 relie le système électronique au boîtier 2 et permet de dissiper la puissance perdue par le système électronique.

Le support 10 est métallique, et possède donc une conductivité thermique élevée. La paroi de la conduite 9 du système de refroidissement 8 est reliée au support 10. Ainsi, il y a un transfert de chaleur par conduction entre le système électronique, son support 10 et le système de refroidissement 8.

Sur la figure 3 est représenté l'intérieur d'un système de refroidissement 8. Deux ventilateurs 11 et 12 sont disposés aux extrémités du système de refroidissement 8. Les ventilateurs 11 et 12 sont respectivement associés aux ouvertures 5 et 7.

Les moyens de commande de ces ventilateurs 11 et 12 sont indépendants. Une défaillance de l'alimentation électrique d'un des deux ventilateurs 11 ou 12 n'entraîne donc pas l'arrêt de l'autre ventilateur 11 ou 12. Le système de refroidissement 8 est donc robuste à une panne d'un des deux ventilateurs 11 ou 12.

Des ailettes de dissipation thermiques 13 sont disposées à l'intérieur du système de refroidissement entre les ventilateurs 11 et 12. La chaleur transférée par conduction à travers le support 10 et la conduite 7 est ensuite dissipée dans les ailettes 13. Un transfert par convection permet de refroidir ces ailettes 13 et l'ensemble du boîtier 2, en faisant circuler un flux d'air dans le système de refroidissement 8, en utilisant les ventilateurs 11 et 12.

Lors d'une défaillance du système électronique inclus dans le boîtier 2, un départ de feu peut apparaître. Le système de refroidissement 8, qui utilise un refroidissement par convection forcée, ne peut pas apporter de l'oxygène à ce système électronique enflammé. En outre, les fumées sont contenues à l'intérieur du boîtier 2.

L'invention n'est pas limitée au mode de réalisation décrit précédemment en référence aux figures 1, 2 et 3.

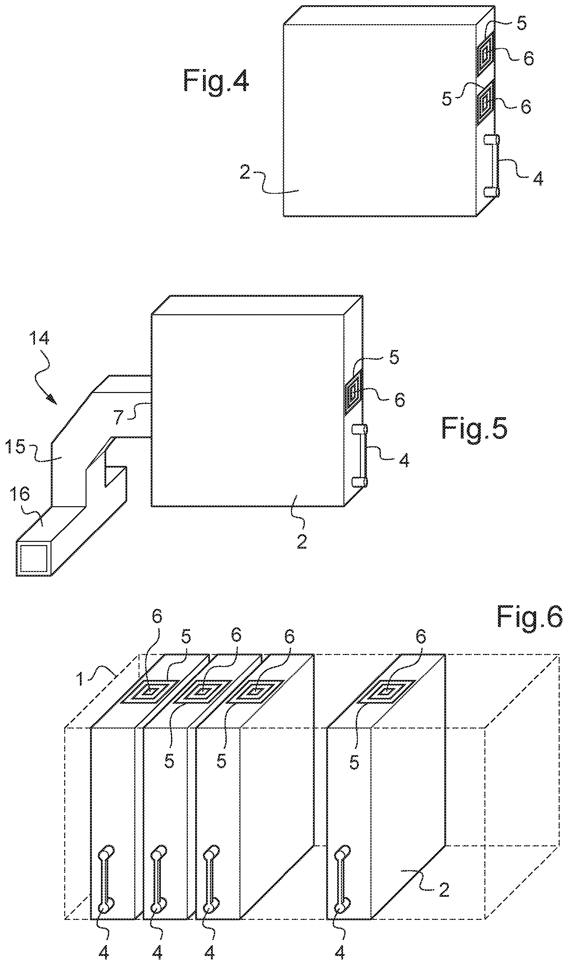

En se référant aux figures 4 à 6, sur lesquelles des éléments identiques à ceux décrits en référence aux figures 1, 2 et 3 portent les même références numériques, la disposition du système de refroidissement peut être modifiée et d'autres éléments peuvent être ajoutés.

Par exemple, comme visible sur la figure 4, la face avant du boîtier 2 comporte une deuxième ouverture 5 équipée d'une deuxième grille 6. Le boîtier comporte donc deux systèmes de refroidissement 8 et deux conduits 9 qui le traverse. L'efficacité du refroidissement est donc accrue.

Dans le mode de réalisation de la figure 5, la deuxième ouverture 7 du boîtier est reliée à un système d'extraction d'air extérieur 14. Ce système d'extraction d'air comprend une première conduite 15 reliée à l'ouverture 7. Une deuxième conduite 16 est connectée à la première conduite 15. La deuxième conduite 16 peut extraire l'air chaud du boîtier 2 et l'air chaud des boîtiers 2 voisins. Le système d'extraction d'air 14 peut en outre permettre de ne pas évacuer l'air chaud directement dans l'air environnant du boîtier 2.

Selon encore un autre mode de réalisation illustré sur la figure 6, l'ouverture 5 est située sur la face supérieure du boîtier 2. L'ouverture 7, non représentée, est située sur la face inférieure du boîtier. Le système de refroidissement, vertical, n'évacue pas d'air sur des faces situées en regard d'une face d'un autre boîtier 2.

Avantageusement, le flux d'air traversant le système de refroidissement 8 peut circuler de la première ouverture 5 vers la deuxième ouverture 7 ou de la deuxième ouverture 7 vers la première ouverture 5.

On notera que ces divers modes de réalisation peuvent également être combinés.

Grâce à l'invention, on bénéficie d'un dispositif de protection d'un système électronique apte à confiner les fumées à l'intérieur du dispositif et à empêcher l'apport d'oxygène lors d'un départ de feu.

On bénéficie également d'un système de refroidissement autonome et robuste à la panne d'un ventilateur.

Le boîtier obtenu permet en outre de protéger les systèmes électroniques contenus contre les perturbations électromagnétiques émises et reçues.

## Revendications

1. Dispositif de protection d'un système électronique, comprenant un boîtier (2) destiné à recevoir le système électronique et à être monté dans un rack (3) d'un système de rangement (1) pouvant recevoir plusieurs boîtiers (2), ledit boîtier (2) comprenant une première ouverture (5) située sur une première de ses faces, une deuxième ouverture (7) sur une deuxième de ses faces, et un système de refroidissement (8) comprenant une conduite (9) reliant les ouvertures (5, 7), la paroi de la conduite étant hermétique, **caractérisé en ce que** le système de refroidissement (8) comporte un premier ventilateur (11) associé à la première ouverture (5) et un deuxième ventilateur (12) associé à la deuxième ouverture (7), les moyens de commande des ventilateurs étant indépendants, la paroi de la conduite du système de refroidissement étant reliée à un support destiné à recevoir un système électronique.

2. Dispositif selon la revendication 1, **caractérisé en ce que** le boîtier est métallique.

3. Dispositif selon la revendication 1, **caractérisé en ce que** le système de refroidissement (8) comporte des moyens de dissipation de chaleur (13) situés entre le premier ventilateur (11) et le deuxième ventilateur (12).

4. Dispositif selon l'une des revendications 1 à 3, **caractérisé en ce que** le système électronique est relié au boîtier (2) par un support (10) apte à dissiper la puissance perdue par le système électronique.

5. Dispositif selon l'une quelconque des revendications précédentes, **caractérisé en ce que** le système de refroidissement (8) est relié à un système d'extraction d'air extérieur (14).

6. Dispositif selon l'une quelconque des revendications précédentes, **caractérisé en ce que** le flux d'air traversant le système de refroidissement (8) circule de la première ouverture (5) vers la deuxième ouverture (7) ou de la deuxième ouverture (7) vers la première ouverture (5).

7. Dispositif selon l'une quelconque des revendications précédentes, **caractérisé en ce que** ladite première face est la face accessible du boîtier (2) ou face avant, et ladite deuxième face est la face arrière du boîtier (2).

8. Dispositif selon l'une des revendications 1 à 5, **caractérisé en ce que** ladite première face est la face inférieure du boîtier (2), et ladite deuxième face est la face supérieure du boîtier (2).

9. Dispositif selon l'une quelconque des revendications précédentes, **caractérisé en ce qu'**il comprend sur ladite première face deux ouvertures (5), sur ladite deuxième face deux ouvertures (7), deux systèmes de refroidissement (8) comprenant chacun une conduite (9) reliant les ouvertures (5) de la première face aux ouvertures (7) de la deuxième face.

## Patentansprüche

1. Vorrichtung zum Schutz eines elektronischen Systems, welche ein Gehäuse (2) umfasst, das dazu bestimmt ist, das elektronische System aufzunehmen und in einem Rack (3) eines Lagersystems (1) montiert zu werden, das mehrere Gehäuse (2) aufnehmen kann, wobei das Gehäuse (2) eine erste Öffnung (5), die sich auf einer ersten seiner Seiten befindet, eine zweite Öffnung (7) auf einer zweiten seiner Seiten und ein Kühlsystem (8), das ein Leitungsrohr (9) umfasst, das die Öffnungen (5, 7) verbindet, umfasst, wobei die Wand des Leitungsrohres hermetisch ist, **dadurch gekennzeichnet, dass** das Kühlsystem (8) einen ersten Lüfter (11), welcher der ersten Öffnung (5) zugeordnet ist, und einen zweiten Lüfter (12), welcher der zweiten Öffnung (7) zugeordnet ist, aufweist, wobei die Steuerungsmittel der Lüfter unabhängig sind, wobei die Wand des Leitungsrohres des Kühlsystems mit einem Träger verbunden ist, der dazu bestimmt ist, ein elektronisches System aufzunehmen.

2. Vorrichtung nach Anspruch 1, **dadurch gekennzeichnet, dass** das Gehäuse metallisch ist.

3. Vorrichtung nach Anspruch 1, **dadurch gekennzeichnet, dass** das Kühlsystem (8) Mittel zur Wärmeableitung (13) aufweist, die sich zwischen dem ersten Lüfter (11) und dem zweiten Lüfter (12) befinden.

4. Vorrichtung nach einem der Ansprüche 1 bis 3, **dadurch gekennzeichnet, dass** das elektronische System mit dem Gehäuse (2) durch einen Träger (10) verbunden ist, der geeignet ist, die von dem elektronischen System erzeugte Verlustleistung abzuleiten.

5. Vorrichtung nach einem der vorhergehenden Ansprüche, **dadurch gekennzeichnet, dass** das Kühlsystem (8) mit einem System zum Abführen von Außenluft (14) verbunden ist.

6. Vorrichtung nach einem der vorhergehenden Ansprüche, **dadurch gekennzeichnet, dass** der durch das Kühlsystem (8) strömende Luftstrom von der ersten Öffnung (5) zur zweiten Öffnung (7) oder von der zweiten Öffnung (7) zur ersten Öffnung (5) zirkuliert.

7. Vorrichtung nach einem der vorhergehenden Ansprüche, **dadurch gekennzeichnet, dass** die erste Seite die zugängliche Seite des Gehäuses (2) oder Vorderseite ist und die zweite Seite die Rückseite des Gehäuses (2) ist.

8. Vorrichtung nach einem der Ansprüche 1 bis 5, **dadurch gekennzeichnet, dass** die erste Seite die Unterseite des Gehäuses (2) ist und die zweite Seite die Oberseite des Gehäuses (2) ist.

9. Vorrichtung nach einem der vorhergehenden Ansprüche, **dadurch gekennzeichnet, dass** sie auf der ersten Seite zwei Öffnungen (5), auf der zweiten Seite zwei Öffnungen (7) und zwei Kühlsysteme (8), die jeweils ein Leitungsrohr (9) umfassen, das die Öffnungen (5) der ersten Seite mit den Öffnungen (7) der zweiten Seite verbindet, umfasst.

## Claims

1. Device for protecting an electronic system, comprising a case (2) intended to receive the electronic system and to be mounted in a rack (3) of a storage system (1) that can receive a number of cases (2), said case (2) comprising a first opening (5) situated on a first of its faces, a second opening (7) on a second of its faces, and a cooling system (8) comprising a duct (9) linking the openings (5, 7), the wall of the duct being air-tight, **characterized in that** the cooling system (8) includes a first fan (11) associated with the first opening (5) and a second fan (12) associated with the second opening (7), the control means for the fans being independent, the wall of the duct of the cooling system being linked to a support intended to receive an electronic system.

2. Device according to Claim 1, **characterized in that** the case is metallic.

3. Device according to Claim 1, **characterized in that** the cooling system (8) includes heat dissipation means (13) situated between the first fan (11) and the second fan (12).

4. Device according to one of Claims 1 to 3, **characterized in that** the electronic system is linked to the case (2) by a support (10) suitable for dissipating the power lost by the electronic system.

5. Device according to any one of the preceding claims, **characterized in that** the cooling system (8) is linked to an external air extraction system (14).

6. Device according to any one of the preceding claims, **characterized in that** the flow of air passing through the cooling system (8) circulates from the first opening (5) to the second opening (7) or from the second opening (7) to the first opening (5).

7. Device according to any one of the preceding claims, **characterized in that** said first face is the accessible face of the case (2), or front face, and said second face is the rear face of the case (2).

8. Device according to one of Claims 1 to 5, **characterized in that** said first face is the bottom face of the case (2) and said second face is the top face of the case (2).

9. Device according to any one of the preceding claims, **characterized in that** it comprises, on said first face, two openings (5), on said second face, two openings (7), two cooling systems (8) each comprising a duct (9) linking the openings (5) of the first face to the openings (7) of the second face.
